# EUROPEAN PATENT APPLICATION

(11) **EP 4 738 836 A1**
(43) Date of publication of application: **06.05.2026**
(21) Application number: 24306854.1
(22) Date of filing: 04.11.2024
(51) Int. Cl.: H04N 21/233, G06F 3/01, H03M 7/30, H04N 21/41, H04N 21/439, H04N 21/485

(54) **MPEG HAPTICS SYNTHESIZER OPTIMIZATION FOR GENERATING HIGH FREQUENCY SIGNAL**

(71) Applicant: InterDigital CE Patent Holdings, SAS, 75017 Paris (FR)
(72) Inventor: LECUYER, Gurvan, 35000 RENNES (FR); GALVANE, Quentin, 35235 THORIGNE-FOUILLARD (FR); GUILLOTEL, Philippe, 35770 VERN SUR SEICHE (FR)
(74) Representative: Vossius & Partner Patentanwälte Rechtsanwälte mbB

(57) **Abstract**

A system, codec and method of optimizing an MPEG haptics synthesizer are disclosed. The method includes determining a minimum sampling rate, generating a haptic signal with the determined minim sampling rate and upsampling the generated haptic signal to synthesize a final haptic signal. The optimizing may include determining a minimum sampling rate by an end user, by an automatic computation. The optimizing may include upsampling of the generated haptic signal based on a target sampling rate. The optimizing may include the defined by content creator causes a value of the minimum sampling rate to be stored with haptic data. The optimizing may include, in a context of the MPEG haptic standard, the minimum sampling rate being part of the normative part of the specification, the minimum sampling rate being stored as an optional value of a haptic experience level, or the minimum sampling rate being stored for each band.

## Description

### BACKGROUND

The current implementation of the synthesizer is using a loop over the whole data structure to generate the final signal. The signal generation computational cost is growing linearly with the sample rate value. The signal generation computational cost grows even more when a high number of keyframes are used to describe the haptic effect.

### SUMMARY

A system, codec and method of optimizing an MPEG haptics synthesizer are disclosed. The method includes determining a minimum sampling rate, generating a haptic signal with the determined minim sampling rate and upsampling the generated haptic signal to synthesize a final haptic signal. The method may include determining a minimum sampling rate by an end user. The method may include determining a minimum sampling rate by an automatic computation. The method may include upsampling of the generated haptic signal based on a target sampling rate. The method may include the minimum sampling rate being based on at least one of defined by a content creator and stored in the MPEG haptic format, automatically computed using signal analysis, and specified directly as a parameter of the MPEG haptic synthesizer by a user. The method may include the defined by content creator causes a value of the minimum sampling rate to be stored with haptic data. The method may include, in a context of the MPEG haptic standard, the minimum sampling rate being part of the normative part of the specification, the minimum sampling rate being stored as an optional value of a haptic experience level, or the minimum sampling rate being stored for each band of a data structure. The method may include the minimum sampling rate being automatically computed and used to generate the haptic signal. The method may include the minimum sampling rate being based on an upper maximum frequency stored at a band level. The method may include the minimum sampling rate being a synthesizer parameter. The method may include the minimum sampling rate being provided at a time of synthesis. The method may include an end user determining a value of the minimum sampling rate.

The codec includes a haptic synthesizer operating to determine a minimum sampling rate, generate a haptic signal with the determined minim sampling rate and upsample the generated haptic signal to synthesize a final haptic signal. The codec may include the haptic synthesizer being further configured to determine the minimum sampling rate by an automatic computation. The codec may include the upsampling of the generated haptic signal being based on a target sampling rate. The codec may include the minimum sampling rate being based on at least one of defined by a content creator and stored in a MPEG haptic format, automatically computed using signal analysis, and specified directly as a parameter of the haptic synthesizer by a user. The codec may include, in a context of a MPEG haptic standard, the minimum sampling rate being part of the normative part of the specification, stored as an optional value of a haptic experience level, or stored for each band of a data structure. The codec may include the minimum sampling rate being automatically computed and used to generate the haptic signal.

### BRIEF DESCRIPTION OF THE DRAWINGS

A more detailed understanding may be had from the following description, given by way of example in conjunction with the accompanying drawings, wherein like reference numerals in the figures indicate like elements, and wherein:
FIG. 1 illustrates a moving picture experts group (MPEG) haptics data structure;
FIG. 2 illustrates a haptic signal (bottom) and the decomposition in two frequency bands (top);
FIG. 3 illustrates a haptic encoder architecture according to embodiments of the present invention;
FIG. 4A illustrates the pipeline of the automatic computation of SRₘᵢₙ and synthesis of the final haptic signal according to embodiments of the present invention;
FIG. 4B illustrates the pipeline when the value SRₘᵢₙ is given by the end user for the synthesizer according to embodiments of the present invention;
FIG. 5 illustrates a method of optimizing MPEG haptics synthesizer;
FIG. 6A illustrates a resulting signal when the haptic signal according to an aspect of the present invention is subtracted from a reference signal;
FIG. 6B illustrates a resulting signal when the haptic signal according to an aspect of the present invention is subtracted from a reference signal;
FIG. 6C illustrates a resulting signal when the haptic signal according to an aspect of the present invention is subtracted from a reference signal;
FIG. 6D illustrates a resulting signal when the haptic signal according to an aspect of the present invention is subtracted from a reference signal;
FIG. 6E illustrates a resulting signal when the haptic signal according to an aspect of the present invention is subtracted from a reference signal; and
FIG. 6F illustrates a resulting signal when the haptic signal according to an aspect of the present invention is subtracted from a reference signal.

### DETAILED DESCRIPTION

The moving picture experts group (MPEG) haptic codec synthesizer allows for the choice of the sampling rate of the generated signal. In the reference software, the default value of the sampling rate is set to 8kHz. This 8kHz sampling rate is considered sufficient to encode vibrotactile haptic data (a commonly used modality) since the human threshold for vibrotactile frequency is limited to a range of up to 1kHz. For this frequency value of 8kHz, the synthesizer can process any signal in real-time, meaning that it can generate 1 second of signal in less than 1 second. Since the haptic signal may be assimilated to an audio signal, many haptic device manufacturers use sound card hardware to communicate with the haptic actuator. This type of system can only process signals generated at a minimum of 44.1kHz or more generally 48kHz as it corresponds respectively to standards such as those of CDs and movies. The current implementation of the MPEG haptic codec synthesizer is not able to process signals in real time for these sampling rates.

Audio signals are generally limited to 2 channels, even if they can include more (6 channels for 5.1 system for example). The haptic signal number of channels can quickly increase depending on the device used since each actuator of a haptic device requires a specific channel of the haptic signal. It is common to deal with haptic devices using 20 actuators or more. The number of channels may also impact the computing time of the synthesizer, and sometimes even dramatically.

The current implementation of the synthesizer is using a loop over the whole data structure to generate the final signal. The signal generation computational cost is growing linearly with the sample rate value. The signal generation computational cost grows even more when a high number of keyframes are used to describe the haptic effect.

While the real time capability of the synthesizer is not mandatory for some use cases such as immersive media like dynamic cinema, real time capability of the synthesizer is required for interactive use cases such as VR experience or video games. For the interactive use cases, haptic feedback is particularly important for the immersiveness of the experience. The delay in the rendering of the haptic effect can particularly impact negatively the experience.

With the on-going MPEG standardization process on the coded representation of haptics, a new haptic coding format is being defined. The reference model of this coding format is being developed and the coding format and the encoder are provided in more detail below.

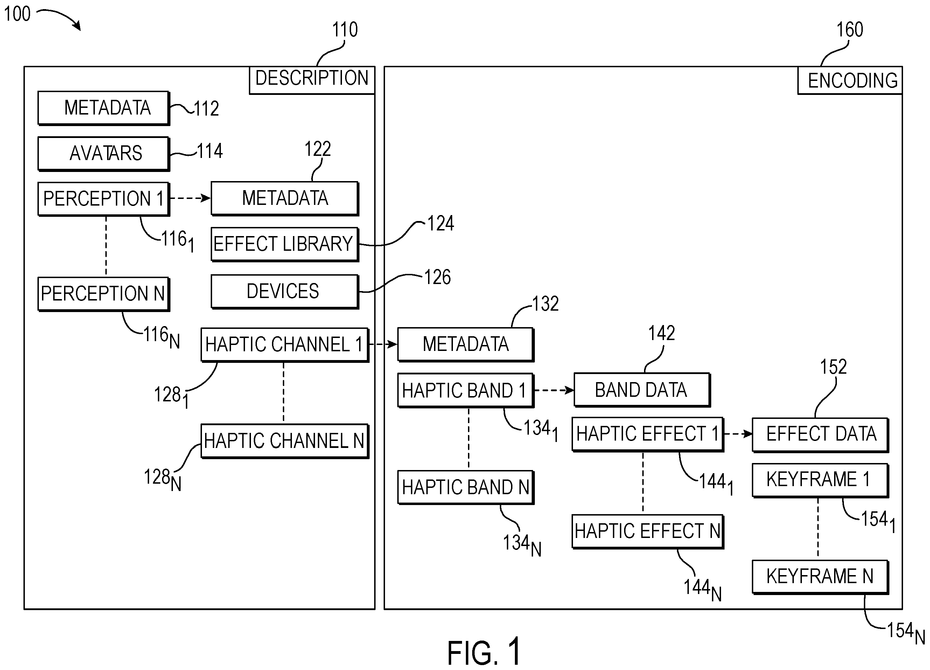

FIG. 1 illustrates a moving picture experts group (MPEG) haptics data structure 100. Data structure 100 of the format follows a hierarchical organization as illustrated in FIG. 1. The file format is divided into a first portion identified as description 110 and a second portion identified as encoding 160. Generally, description 110 includes the haptic information described in metadata and encoding 160 includes the haptic information in the data itself. Within description 110 data structure 100 includes high-level metadata information 112 regarding the overall haptic experience defined in the file. Data structure 100 provides a list of avatars 114 (i.e., body representation) later referenced in the file to specify the desired location of haptic stimuli on the body. The haptic data within the data structure 100 is described through a plurality of perceptions 116 (individually identified as perceptions 116₁ through 116_{N} collectively referred to as plurality of perceptions 116). Plurality of perceptions 116 each correspond to haptic signals associated with specific perception modalities (I.e., vibration, force, position, velocity, temperature, ...).

Each perception in the plurality of perceptions 116 includes metadata 122, an effect library 124, devices 126, and a plurality of haptic channels 128 (individually identified as haptic channels 128₁ through 128_{N} collectively referred to as plurality of haptic channels 128). Within plurality of haptic channels 128, the data is decomposed in frequency haptic bands 134 (individually identified as haptic bands 134₁ through 134_{N} collectively referred to as haptic bands 134) and metadata 132. Each haptic band 134 defines part of the signal in a given frequency range. The haptic band 134 includes band data 142 and a plurality of haptic effects 144 (individually identified as haptic effects 144₁ through 144_{N} collectively referred to as plurality of haptic effects 144). Each haptic effect 144 includes effect data 152 and a plurality of keyframes 154 (individually identified as keyframes 154₁ through 154_{N} collectively referred to as plurality of keyframes 154). The haptic signal in a track can then be reconstructed by combining the data in the different bands.

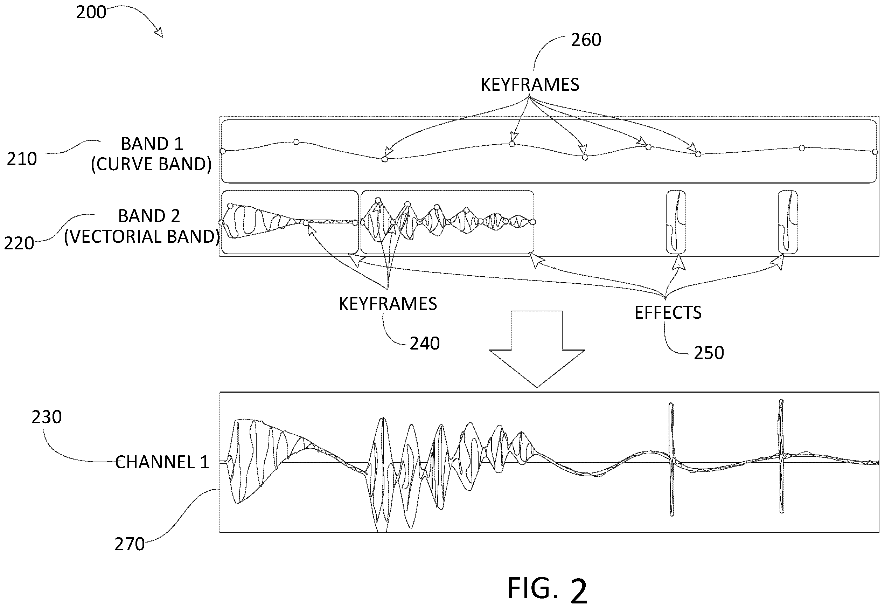

FIG. 2 illustrates a depiction 200 of a haptic signal 270 and the decomposition in two frequency bands 210, 220. Specifically, FIG. 2 illustrates how a haptic signal 270 is decomposed in two frequency bands (Band 1 210 and Band 2 220). As illustrated, band 1 210 is a low frequency band and band 2 220 is a high frequency band. By adding the high frequency band of band 2 220 and low frequency band of band 1 210, the original signal on channel 1 230 can be reconstructed in haptic signal 270 on channel 1 230.

Four types of haptic bands may be used including transient bands, curve bands, vectorial wave bands and wavelet bands. Each band (illustrated as band 1 210 and band 2 220) is composed of a series of "effects" 250 that are each defined by a list of "keyframes" 240, 260. The data contained in effects 250 and keyframes 240, 260 is interpreted differently for different types of haptic bands and encoding modalities.

Specifically, in FIG. 2, band 1 210 is a curve band that includes keyframes 260 within the low frequency curve of the curve band. Each effect stores a set of keyframes 260 defining a position and an amplitude. Keyframes 260 represent the control points of the curve of band 1 210.

Band 2 220 is a vectorial band that includes a series of higher frequency signals using frequency modulation envelops. Band 2 220 includes keyframes 240 and effects 250. Each effect 250 respectively stores a set of keyframes 240 defining a position, an amplitude and a frequency.

In an example, for a transient band, each effect may store a set of keyframes defining a position, an amplitude, and a frequency. A keyframe represents a transient event in such a configuration.

In a curve band, for example, each effect stores a set of keyframes defining a position and an amplitude. The keyframes represent the control points of the curve. The type of interpolation function (i.e., cubic or linear) used to generate the band may be specified in the metadata of the band.

For vectorial wave bands, for example, the effect stores a set of keyframes defining a position, an amplitude and a frequency. For wavelet bands, for example, the effect stores the contents of one wavelet block binary stream.

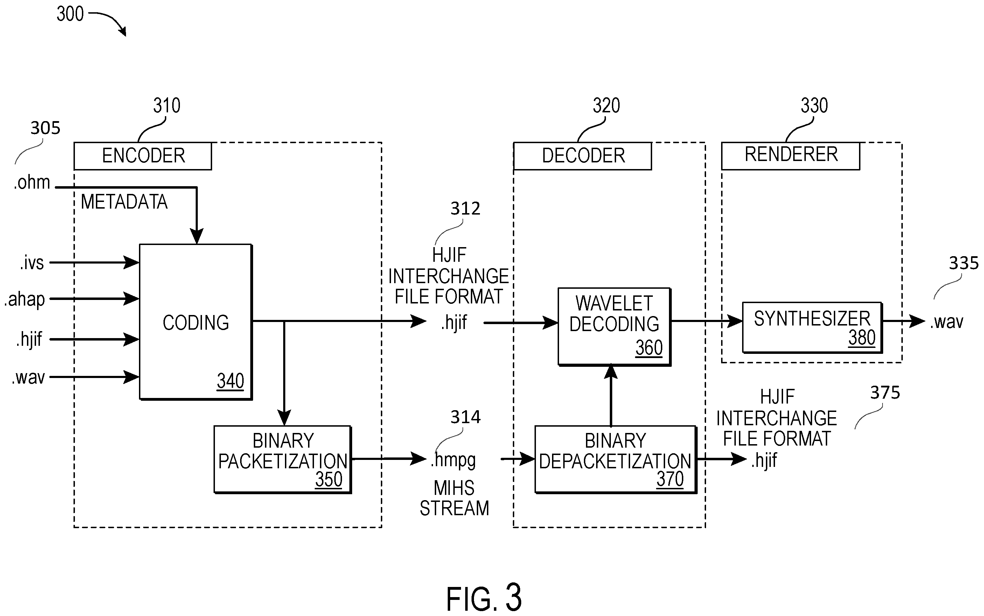

FIG. 3 illustrates a haptic codec architecture 300 according to embodiments of the present invention. The encoded signal may be exported either as a JSON (human readable) interchange format or as a compressed binary distribution format. Architecture 300 includes at a high level an encoder 310, decoder 320 and a renderer 330. Encoder 310 includes the coding 340 of inputs 305 for an output in an interchange file format 312, and as necessary the binary packetization 350 of the signal in a stream format 314. As is understood, the interchange file format 312 may include HJIF (.hjif) and the streaming format 314 may include an MIHS stream (.hmpg). The signals output from the encoder 310 are received in the decoder 320 where wavelet decoding 360 may be performed in the interchange file format 312 and binary depacketization 370 may be performed on the stream format 314. The binary depacketization 370 may then output an interchange file format 375 that may be in HJIF (.hjif), for example. The wavelet decoded 360 signal may be input to the renderer 330 utilizing a synthesizer 380 that provides an output 335. Output 335 from synthesizer 380 may take the form of a .wav file for example.

The encoding process may take an input 305 either descriptive haptics files (.IVS and .AHAP) or waveform PCM files (.wav). The encoding 340 of these two types of file formats follows two distinct approaches. For descriptive input files, the encoder 310 first analyzes the data and then transcodes the data directly to the MPEG format. For waveform signals, the data is processed using more common signal analysis methods to generate keyframes and either interpolate between keyframes or use wavelet coding (based on SPITH) to generate a binary encoded stream.

In an embodiment, there is an optimized MPEG haptic codec synthesizer. Given a target sampling rate SR_{target}, and a minimum sampling rate SRₘᵢₙ, the MPEG haptic codec synthesizer generates the haptic signal using SRₘᵢₙ. After generating the signal, the generated haptic signal is upsampled to match SR_{target}. The parameter SRₘᵢₙ may be defined by the content creator and stored in the MPEG haptic format, automatically computed using signal analysis, or specified directly as a parameter of the MPEG haptic synthesizer by the user.

For example, when the SRₘᵢₙ is determined by content creator, the value of the parameter may be stored along with the haptic data. In the context of the MPEG haptic standard, this information is part of the normative part of the specification. In other embodiments to the MPEG haptic format, another format may be used.

In the context of the MPEG haptic standard, the value SRₘᵢₙ may be stored as an optional value of the haptic experience level in the data structure shown FIG. 1. Table 1 illustrates an implementation of the storage of SRₘᵢₙ at the haptic experience level.

**Table 1 - implementation at the Haptic Experience level.**

| **Property** | **Description** |
|---|---|
| **Version** | Year of the edition and amendment of ISO/IEC 23090-31 that this file conforms to, in the following format: XXXX or XXXX-Y, where XXXX is the year of publication and Y is the amendment number, if any. |
| **Profile** | Name of the profile used to generate the encoded stream as defined in the normative section. |
| **Level** | Number of the level used to generate the encoded stream as defined in the normative section. |
| **Date** | Creation date of this haptic experience. |
| **description** | A user description of this haptic experience. |
| **Timescale** | Number of ticks per second. |
| **SRₘᵢₙ** | Sample rate minimum to use for synthesizing the haptic signal before being upsampled. |
| **Avatars** | List of avatars defining body representations used in the haptic experience. |
| **perceptions** | List of perceptions describing a haptic signal. |

Another embodiment in the MPEG haptic standard is to store this value SRₘᵢₙ for each band of the data structure as described with respect to FIG. 1. In this embodiment, extra processing may be required when rendering the signal to mix the different bands of each channel of the experience. Table 2 illustrates an implementation at the haptic band level.

**Table 2 - implementation at the haptic band level.**

| **Property** | | **Description** |
|---|---|---|
| **band type** | | Type of data contained in the band. There are four types of haptic bands: curve bands, transient bands, vectorial wave bands and wavelet wave bands. For each type of band, the information it contains has a different meaning: |
| | Curve bands represent haptic signals with curves, described by a set of control points and a type of interpolation in-between. | |
| | Transient bands represent short momentary haptic effects, described with amplitude and frequency parameters. | |
| | Vectorial wave bands represent parametric haptic effects; described by a vector of parameters including temporal or spatial position, amplitude and frequency. The model allows both amplitude and frequency modulation of the signal. | |
| | Wavelet wave bands represent haptic effects encoded with wavelet transform decomposition, quantization, binary tree structure, and entropy coding. | |
| **Priority** | | Importance of the band for scalability. A lower value indicates higher priority. Given a limited bandwidth, decoders may ignore perception with a higher priority value. |
| **Curve type** | | Present only for curve bands. This specifies the interpolation method Boolean be used to synthetize the haptic signal of the band. Possible values are: |
| | Linear | |
| | Cubic | |
| | Akima | |
| | Bézier | |
| | B-spline | |
| | Unknown (for application specific functions) | |
| **block length** | | This property is only present for wavelet wave bands. It is the duration of a wavelet block. |
| **Lower frequency limit** | | Lower frequency limit of the band (Hz). |
| **Upper frequency limit** | | Upper frequency limit of the band (Hz). |
| **SRₘᵢₙ** | | Sample rate minimum to use for synthesizing the haptic signal before being upsampled. |
| **Effects** | | List of haptic effects. If the effect list is empty, the band does not contain haptic data. |

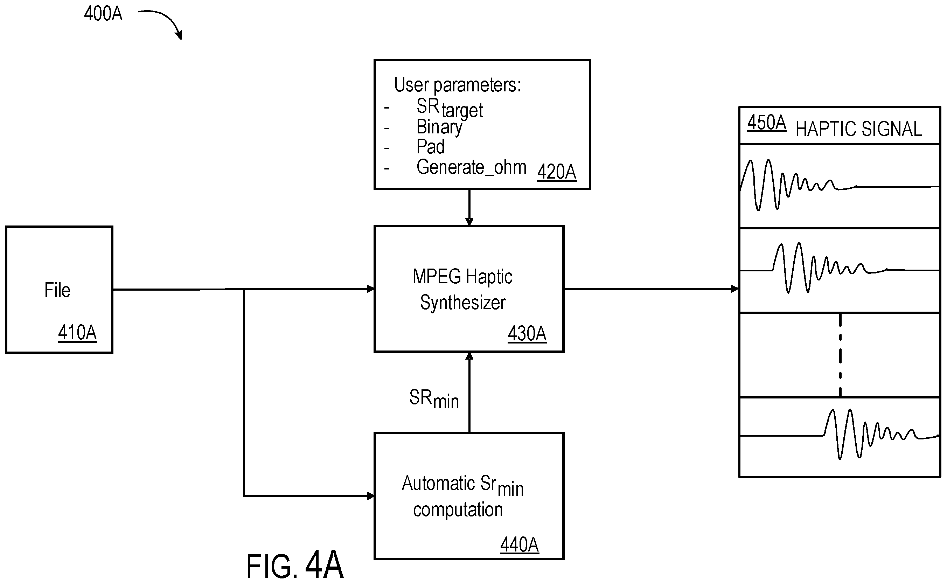

FIG. 4A illustrates a pipeline 400A of the automatic computation of SRₘᵢₙ and synthesis of the final haptic signal according to an aspect of the present invention. In pipeline 400A, a file 410A is provided as input to a MPEG haptic synthesizer 430A and an automatic SRₘᵢₙ computation 440A. User parameters 420A may be provided to the MPEG haptic synthesizer 430A. User parameters may include SR_{target}, binary, pad and generate_ohm, for example, where binary is a boolean specifying whether the input file is a binary file, genrerate_ohm is a boolean indicating if the synthesizer should output a .ohm file which is an optional extra file containing metadata for rendering the haptic data, and SR_{target} provides a target sample rate that the final synthesized haptic signal in output of the synthesizer. Based on the input of file 410A, automatic SRₘᵢₙ computation 440A and user parameters 420A, MPEG haptic synthesizer 430A provides a haptic signal 450A.

The SRₘᵢₙ may be automatically computed in a step and used to generate the haptic. The final haptic signal may be upsampled using the SR_{target}. SRₘᵢₙ may be determined in one of a number of ways. One way to infer the minimum Sampling Rate may be to rely on the upper maximum frequency stored at the band level. Using the Nyquist theorem, sampling at twice the maximum frequency of signal ensure to perfectly reconstruct the encoded signal. Another technic may be to rely on the frequency information stored at the keyframe level, ensuring an even more accurate estimation of the minimum sampling rate.

To reduce computational time, a user or application may choose to reduce the SRₘᵢₙ below the lossless threshold. The tradeoff between computational time and quality of the rendering may then be configured directly by the application.

Finally, since the computational time for the synthesis of the data is linearly dependent on the target bitrate, the synthesizer may take include a ratio specifying the desired computational time gain. This ratio may be used to compute SRₘᵢₙ.

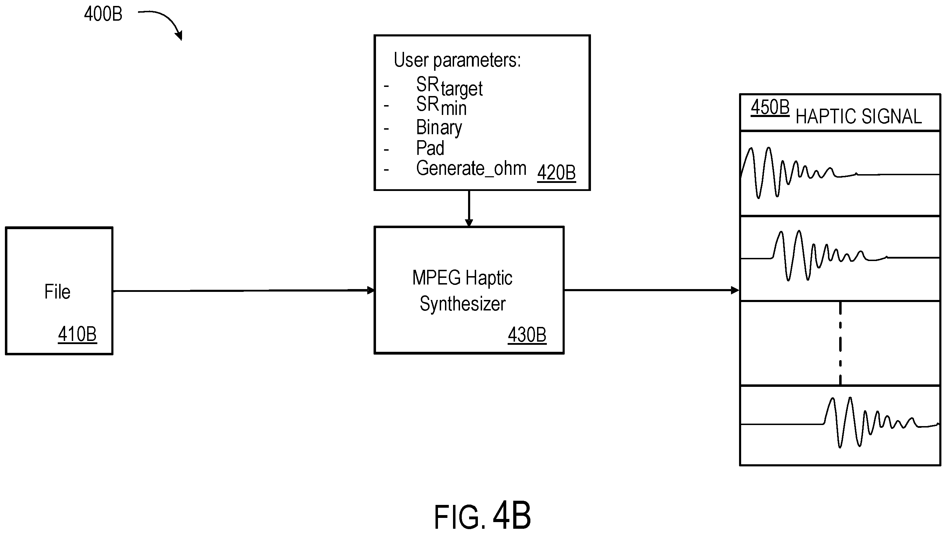

FIG. 4B illustrates a pipeline configured where SRₘᵢₙ is implemented in the context of the MPEG haptic as part of the informative section of the standard. SRₘᵢₙ may be used as a synthesizer parameter. For example, SRₘᵢₙ may be provided at the synthesis time. In such a configuration, the end user may determine the value of the parameter. In pipeline 400B, similar to pipeline 400A described above, a file 410B is provided as input to a MPEG haptic synthesizer 430B. User parameters 420B may be provided to the MPEG haptic synthesizer 430B. User parameters may include SRₘᵢₙ, SR_{target}, binary, pad and generate_ohm, for example, where SR_{target}, binary, pad and generate_ohm are as described in FIG. 4A, and SRₘᵢₙ is the sample rate minimum to use for synthesizing the haptic signal before being upsampled. SRₘᵢₙ is provided in user parameters 420B as opposed to automatically computed as described above. Based on the input of file 410B and user parameters 420B, MPEG haptic synthesizer 430B provides a haptic signal 450B.

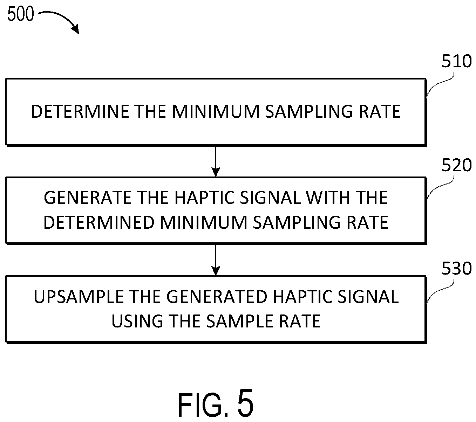

FIG. 5 illustrates a method 500 of optimizing MPEG haptics synthesizer. Method 500 includes at 510, determining the minimum sampling rate SRₘᵢₙ. At 520, method 500 includes generating the haptic signal with the determined minimum sampling rate SRₘᵢₙ. At 530, method 500 includes upsampling the generated haptic signal using the sampling rate SR_{target} to produce the haptic signal. In an embodiment, the end user may determine the value of the SRₘᵢₙ. In an embodiment, an automatic computation of SRₘᵢₙ may be used to determine SRₘᵢₙ. Method 500 may include synthesizing the final haptic signal.

In an embodiment, there is an optimized MPEG haptic codec synthesizer. Given a target sampling rate SR_{target}, and a minimum sampling rate SRₘᵢₙ, the MPEG haptic codec synthesizer generates the haptic signal using SRₘᵢₙ. After generating the signal, the generated haptic signal is upsampled to match SR_{target}. The parameter SRₘᵢₙ may be defined by the content creator and stored in the MPEG haptic format, automatically computed using signal analysis, or specified directly as a parameter of the MPEG haptic synthesizer by the user.

For example, when the SRₘᵢₙ is determined by content creator, the value of the parameter may be stored along with the haptic data. In the context of the MPEG haptic standard, this information is part of the normative part of the specification. In other embodiments to the MPEG haptic format, another format may be used.

In the context of the MPEG haptic standard, the value SRₘᵢₙ may be stored as an optional value of the haptic experience level in the data structure shown FIG. 1.

Another embodiment in the MPEG haptic standard is to store this value SRₘᵢₙ for each band of the data structure as described with respect to FIG. 1. In this embodiment, extra processing may be required when rendering the signal to mix the different bands of each channel of the experience.

The SRₘᵢₙ may be automatically computed in a step and used to generate the haptic. The final haptic signal may be upsampled using the SR_{target}. SRₘᵢₙ may be determined in one of a number of ways. One way to infer the minimum Sampling Rate may be to rely on the upper maximum frequency stored at the band level.

SRₘᵢₙ may be used as a synthesizer parameter. For example, SRₘᵢₙ may be provided at the synthesis time. In such a configuration, the end user may determine the value of the parameter.

The embodiments described herein are tested within the reference software, where the SRₘᵢₙ is set as an input parameter. The signal of multiple test contents using different SRₘᵢₙ values is determined and compared the computational time with the computational times of the current reference software, and the peak signal-to-noise ratio (PSNR) value is calculated by comparing the two outputs.

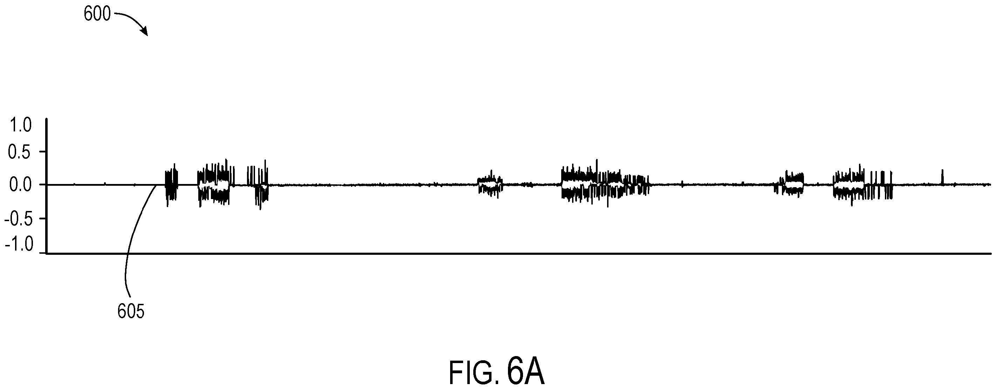

Content 1 is a haptic experience that encodes a single perception with a single channel and a single band. The haptic signal is a 4-second-long signal of real data encoded using wavelet band. In a measurement, content 1 is used with an SR_{target} of 8kHz with a provided SRₘᵢₙ set to 2kHZ with a ref soft time of 0.8 seconds and proposal time of 0.2 seconds provides a PSNR of 36.5 dB. The resulting signal compared to the reference by subtracting the signal from the reference is provided in FIG. 6A. The signal comparison 600 in FIG. 6A provides a signal 605 that provides a max amplitude of 0.3 in a few periodic sections corresponding to the very high frequency part of the original signal. The observed difference is not surprising as the content 1 file contains real data. By using a greater value for SRₘᵢₙ this error may be further suppressed.

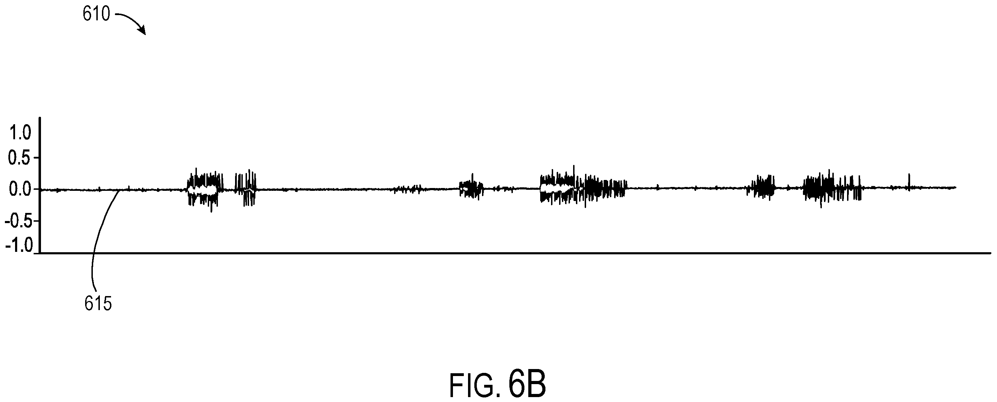

In a measurement, content 1 is used with an SR_{target} of 8kHz with a provided SRₘᵢₙ set to 1kHZ with a ref soft time of 0.8 seconds and proposal time of 0.1 seconds provides a PSNR of 36.6 dB. The resulting signal compared to the reference by subtracting the signal from the reference is provided in FIG. 6B. The signal comparison 610 in FIG. 6B provides a signal 615 that provides a max amplitude of 0.3 in a few periodic sections corresponding to the very high frequency part of the original signal. The observed difference is not surprising as the content 1 file contains real data. By using a greater value for SRₘᵢₙ this error may be further suppressed.

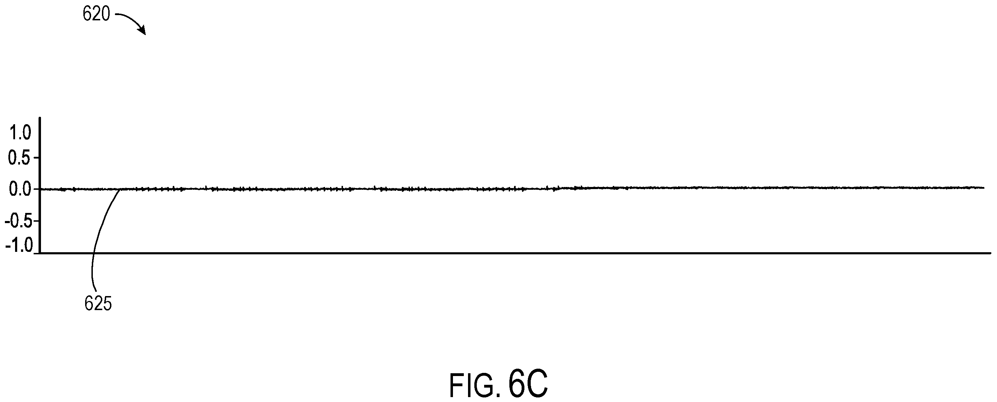

Content 2 is a haptic experience that encodes a single perception with a single channel and a single band. The signal duration is 3 seconds including data defined using a parametric format. In a measurement, content 2 is used with an SR_{target} of 8kHz with a provided SRₘᵢₙ set to 2kHZ with a ref soft time of 0.2 seconds and proposal time of 0.06 seconds provides a PSNR of 51.7 dB. The resulting signal compared to the reference by subtracting the signal from the reference is provided in FIG. 6C. The signal comparison 620 in FIG. 6C provides a signal 625 that provides a max amplitude of approximately 0 without any appreciable mismatch. It shows that, even if the implementation of the invention does not match the original implementation perfectly, the present embodiment is able to synthesize a high quality signal.

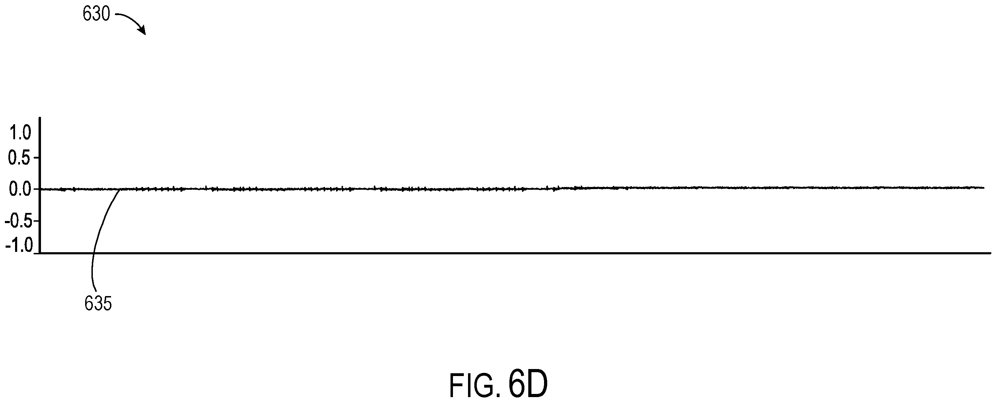

In a measurement, content 2 is used with an SR_{target} of 8kHz with a provided SRₘᵢₙ set to 1kHZ with a ref soft time of 0.2 seconds and proposal time of 0.03 seconds provides a PSNR of 60.6 dB. The resulting signal compared to the reference by subtracting the signal from the reference is provided in FIG. 6D. The signal comparison 630 in FIG. 6D provides a signal 635 that provides a max amplitude of approximately 0 without any appreciable mismatch. It shows that, even if the implementation of the invention does not match the original implementation perfectly, the present embodiment is able to synthesize high quality signal.

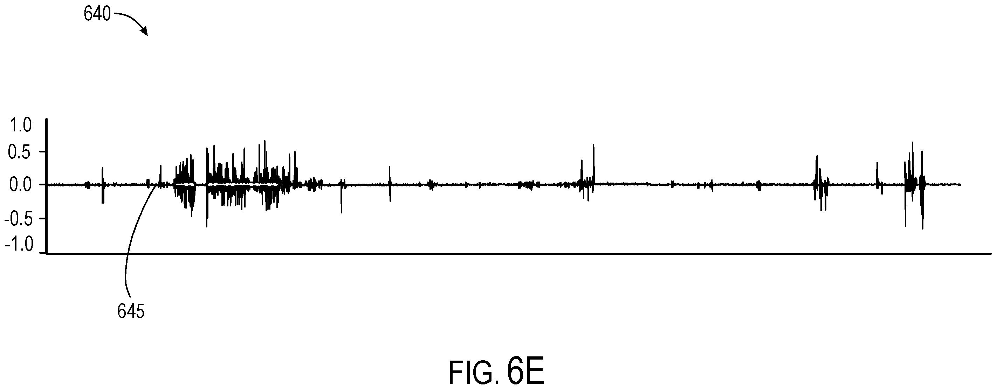

Content 3 is a long haptic experience that encodes a single perception with a single channel and a single band. The signal duration is 1 minute and 12 seconds including data defined using a parametric format. In a measurement, content 3 is used with an SR_{target} of 8kHz with a provided SRₘᵢₙ set to 2kHZ with a ref soft time of 110.9 seconds and proposal time of 27.4 seconds provides a PSNR of 46.3 dB. The resulting signal compared to the reference by subtracting the signal from the reference is provided in FIG. 6E. The signal comparison 640 in FIG. 6E provides a signal 645 that provides a max amplitude of approximately 0.5 with several high frequency bands of mismatch. While the peak error value is high, the signal is long, lasting more than one minute, and therefore the resulting signal achieves a great PSNR value. Signal comparison 640 confirms that the present embodiment is able to synthesize signal a close match to the original synthesizer.

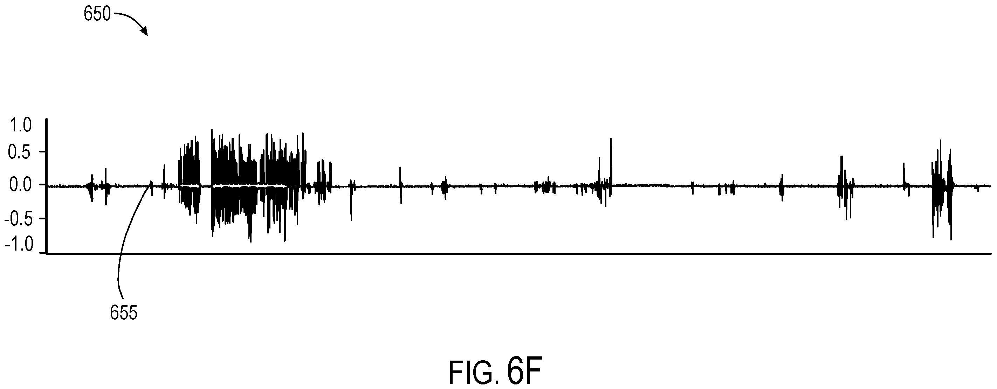

In a measurement, content 3 is used with an SR_{target} of 8kHz with a provided SRₘᵢₙ set to 1kHZ with a ref soft time of 110.9 seconds and proposal time of 14.8 seconds provides a PSNR of 37.3 dB. The resulting signal compared to the reference by subtracting the signal from the reference is provided in FIG. 6F. The signal comparison 650 in FIG. 6F provides a signal 655 that provides a max amplitude of approximately 0.8 with several high frequency bands of mismatch. While the peak error value is high, the signal is long, lasting more than one minute, and therefore the resulting signal achieves a great PSNR value. Signal comparison 650 confirms that the present embodiment is able to synthesize signal a close match to the original synthesizer.

The results of the measurements are detailed in Table 3. Table 3 illustrates that the embodiments provide a faster result than the current MPEG haptic synthesizer. The content 1 and 3 provides additional degradation not seen in the content 2 example. The PSNR values achieved, the lowest score is 36.5dB, are provided that such degradation of the signal is not perceivable. The results were obtained using a basic implementation of the solution, using more advanced techniques to determine SRₘᵢₙ may improve the PSNR scores.

**Table 3: Comparison of computational times for the reference software with different signals and for different SRₘᵢₙ**

| Signal | SR_{t arget} | SR ₘᵢₙ | Ref. Soft Time | Proposal time | PSNR | Signal comparison |
|---|---|---|---|---|---|---|
| Cont ent 1 | 8kH z | 2k Hz | 0.8 s | 0.2 s | 36.5 dB | Illustrat ed in FIG. 6A |
| Cont ent 1 | 8kH z | 1k Hz | 0.8 s | 0.1s | 36.6 dB | Illustrat ed in FIG. 6B |
| Cont ent 2 | 8kH z | 2k Hz | 0.2 s | 0.06s | 51.7 dB | Illustrat ed in FIG. 6C |
| Cont ent 2 | 8kH z | 1k Hz | 0.2 s | 0.03s | 60.6 dB | Illustrat ed in FIG. 6D |
| Cont ent 3 | 8kH z | 2k Hz | 110 .9s | 27.4s | 46.3 dB | Illustrat ed in FIG. 6E |
| Cont ent 3 | 8kH z | 1k Hz | 110 .9s | 14.8s | 37.3 dB | Illustrat ed in FIG.6F |

Various methods are described herein, and each of the methods comprises one or more steps or actions for achieving the described method. Unless a specific order of steps or actions is required for proper operation of the method, the order and/or use of specific steps and/or actions may be modified or combined. Additionally, terms such as "first", "second", etc. may be used in various embodiments to modify an element, component, step, operation, etc., for example, a "first decoding" and a "second decoding". Use of such terms does not imply an ordering to the modified operations unless specifically required. So, in this example, the first decoding need not be performed before the second decoding, and may occur, for example, before, during, or in an overlapping time period with the second decoding.

Moreover, the present aspects are not limited to V-PCC, G-PCC, P11, or V-DMC, and can be applied, for example, to other standards and recommendations, and extensions of any such standards and recommendations. Unless indicated otherwise, or technically precluded, the aspects described in this application can be used individually or in combination. Various numeric values are used in the present application. The specific values are for example purposes and the aspects described are not limited to these specific values.

Various implementations involve decoding. "Decoding," as used in this application, may encompass all or part of the processes performed, for example, on a received encoded sequence in order to produce a final output suitable for display. In various embodiments, such processes include one or more of the processes typically performed by a decoder, for example, entropy decoding, inverse quantization, inverse transformation, and differential decoding. Whether the phrase "decoding process" is intended to refer specifically to a subset of operations or generally to the broader decoding process will be clear based on the context of the specific descriptions and is believed to be well understood by those skilled in the art.

Various implementations involve encoding. In an analogous way to the above discussion about "decoding", "encoding" as used in this application may encompass all or part of the processes performed, for example, on an input video sequence in order to produce an encoded bitstream.

The implementations and aspects described herein may be implemented in, for example, a method or a process, an apparatus, a software program, a data stream, or a signal. Even if only discussed in the context of a single form of implementation (for example, discussed only as a method), the implementation of features discussed may also be implemented in other forms (for example, an apparatus or program). An apparatus may be implemented in, for example, appropriate hardware, software, and firmware. The methods may be implemented in, for example, an apparatus, for example, a processor, which refers to processing devices in general, including, for example, a computer, a microprocessor, an integrated circuit, or a programmable logic device. Processors also include communication devices, for example, computers, cell phones, portable/personal digital assistants ("PDAs"), and other devices that facilitate communication of information between end-users.

Reference to "one embodiment" or "an embodiment" or "one implementation" or "an implementation", as well as other variations thereof, means that a particular feature, structure, characteristic, and so forth described in connection with the embodiment is included in at least one embodiment. Thus, the appearances of the phrase "in one embodiment" or "in an embodiment" or "in one implementation" or "in an implementation", as well any other variations, appearing in various places throughout this application are not necessarily all referring to the same embodiment. Additionally, this application may refer to "determining" various pieces of information. Determining the information may include one or more of, for example, estimating the information, calculating the information, predicting the information, or retrieving the information from memory.

Further, this application may refer to "accessing" various pieces of information. Accessing the information may include one or more of, for example, receiving the information, retrieving the information (for example, from memory), storing the information, moving the information, copying the information, calculating the information, determining the information, predicting the information, or estimating the information.

Additionally, this application may refer to "receiving" various pieces of information. Receiving is, as with "accessing", intended to be a broad term. Receiving the information may include one or more of, for example, accessing the information, or retrieving the information (for example, from memory). Further, "receiving" is typically involved, in one way or another, during operations, for example, storing the information, processing the information, transmitting the information, moving the information, copying the information, erasing the information, calculating the information, determining the information, predicting the information, or estimating the information.

It is to be appreciated that the use of any of the following "/", "and/or", and "at least one of', for example, in the cases of "A/B", "A and/or B" and "at least one of A and B", is intended to encompass the selection of the first listed option (A) only, or the selection of the second listed option (B) only, or the selection of both options (A and B). As a further example, in the cases of "A, B, and/or C" and "at least one of A, B, and C", such phrasing is intended to encompass the selection of the first listed option (A) only, or the selection of the second listed option (B) only, or the selection of the third listed option (C) only, or the selection of the first and the second listed options (A and B) only, or the selection of the first and third listed options (A and C) only, or the selection of the second and third listed options (B and C) only, or the selection of all three options (A and B and C). This may be extended, as is clear to one of ordinary skill in this and related arts, for as many items as are listed.

Also, as used herein, the word "signal" refers to, among other things, indicating something to a corresponding decoder. For example, in certain embodiments the encoder signals a quantization matrix for de-quantization. In this way, in an embodiment the same parameter is used at both the encoder side and the decoder side. Thus, for example, an encoder can transmit (explicit signaling) a particular parameter to the decoder so that the decoder can use the same particular parameter. Conversely, if the decoder already has the particular parameter as well as others, then signaling can be used without transmitting (implicit signaling) to simply allow the decoder to know and select the particular parameter. By avoiding transmission of any actual functions, a bit savings is realized in various embodiments. It is to be appreciated that signaling can be accomplished in a variety of ways.

For example, one or more syntax elements, flags, and so forth are used to signal information to a corresponding decoder in various embodiments. While the preceding relates to the verb form of the word "signal", the word "signal" can also be used herein as a noun.

As will be evident to one of ordinary skill in the art, implementations may produce a variety of signals formatted to carry information that may be, for example, stored or transmitted. The information may include, for example, instructions for performing a method, or data produced by one of the described implementations. For example, a signal may be formatted to carry the bitstream of a described embodiment. Such a signal may be formatted, for example, as an electromagnetic wave (for example, using a radio frequency portion of spectrum) or as a baseband signal. The formatting may include, for example, encoding a data stream and modulating a carrier with the encoded data stream. The information that the signal carries may be, for example, analog or digital information. The signal may be transmitted over a variety of different wired or wireless links, as is known. The signal may be stored on a processor-readable medium.

Although features and elements are described above in particular combinations, one of ordinary skill in the art will appreciate that each feature or element can be used alone or in any combination with the other features and elements. In addition, the methods described herein may be implemented in a computer program, software, or firmware incorporated in a computer-readable medium for execution by a computer or processor. Examples of computer-readable media include electronic signals (transmitted over wired or wireless connections) and computer-readable storage media. Examples of computer-readable storage media include, but are not limited to, a read only memory (ROM), a random access memory (RAM), a register, cache memory, semiconductor memory devices, magnetic media such as internal hard disks and removable disks, magneto-optical media, and optical media such as CD-ROM disks, and digital versatile disks (DVDs). A processor in association with software may be used to implement a radio frequency transceiver for use in a WTRU, UE, terminal, base station, RNC, or any host computer.

## Claims

1. A method of optimizing MPEG haptics synthesizer, the method comprising:
determining a minimum sampling rate;
generating a haptic signal with the determined minimum sampling rate; and
upsampling the generated haptic signal to synthesize a final haptic signal.

2. A codec comprising:
a haptic synthesizer operating to:
determine a minimum sampling rate;
generate a haptic signal with the determined minimum sampling rate; and
upsample the generated haptic signal to synthesize a final haptic signal.

3. The method of claim 1 or the codec of claim 2, wherein the minimum sampling rate is determined based on input from a user.

4. The method of claim 1 or the codec of claim 2, wherein determining a minimum sampling rate is performed by an automatic computation.

5. The method of claim 1 or the codec of claim 2, wherein the upsampling of the generated haptic signal is based on a target sampling rate.

6. The method of claim 1 or the codec of claim 2, wherein the minimum sampling rate is based on at least one of a parameter specified by a content creator and stored in an MPEG haptic format, a parameter computed from a haptic content using signal analysis, and a parameter specified by a user.

7. The method of claim 6 or the codec of claim 6, wherein the parameter specified by the content creator represents a value of the minimum sampling rate.

8. The method of claim 7 or the codec of claim 7, wherein in a context of the MPEG haptic standard, the parameter representing the value of the minimum sampling rate is a normative part of the specification.

9. The method of claim 7 or the codec of claim 7, wherein in a context of the MPEG haptic standard, the parameter representing the value of the minimum sampling rate is an optional parameter defined at a haptic experience level.

10. The method of claim 7 or the codec of claim 7, wherein in the MPEG haptic standard, the parameter representing the value of the minimum sampling rate is stored for each band of a data structure.

11. The method of claim 6 or the codec of claim 6, wherein the minimum sampling rate is automatically computed and used to generate the haptic signal.

12. The method of claim 11 or the codec of claim 11, wherein the minimum sampling rate is based on an upper maximum frequency stored at a band level.

13. The method of claim 6 or the codec of claim 6, wherein the minimum sampling rate is a synthesizer parameter.

14. The method of claim 13 or the codec of claim 13, wherein the minimum sampling rate is provided at a time of synthesis.

15. The method of claim 14 or the codec of claim 14, wherein an end user determines a value of the minimum sampling rate.
